# FASCICULE DE BREVET EUROPEEN

(11) **EP 3 161 883 B1**
(45) Date de publication et mention de la délivrance du brevet: **19.08.2020**
(21) Numéro de dépôt: 15730799.2
(22) Date de dépôt: 23.06.2015
(51) Int. Cl.: H01L 51/44, H01L 27/30

(54) **CELLULES TANDEM MULTIFILS**
TANDEMZELLEN MIT MEHREREN FÄDEN
MULTI-THREAD TANDEM CELLS

(30) Priorité: 26.06.2014 FR 1455994
(43) Date de publication de la demande: 03.05.2017
(73) Titulaire: Commissariat à l'Énergie Atomique et aux Énergies Alternatives, 75015 Paris (FR); Centre National de la Recherche Scientifique, 75016 Paris (FR); Université Savoie Mont Blanc, 73000 Chambéry (FR)
(72) Inventeur: LESCOUET, Alissa, 89300 SAINT AUBIN SUR YONNE (FR); BERSON, Solenn, 73000 Chambéry (FR); CELLE, Caroline, 42700 Firminy (FR); LECHENE, Pierre-Balthazar, 75014 Paris (FR); SIMONATO, Jean-Pierre, 38360 Sassenage (FR)
(74) Mandataire: Nony
(86) Numéro de dépôt international: PCT/EP2015/064141
(87) Numéro de publication internationale: WO 2015/197635

(56) Documents cités:
- WO-A1-2012/106002
- WO-A1-2015/116200
- DE-A1-102004 014 046
- US-A1- 2012 298 170
- JUNG-YONG LEE ET AL: "Transparent and tandem solar cells using solution-processed metal nanowire transparent electrodes", PHOTOVOLTAIC SPECIALISTS CONFERENCE (PVSC), 2009 34TH IEEE, IEEE, PISCATAWAY, NJ, USA, 7 juin 2009 (2009-06-07), pages 2200-2203, XP031626667, ISBN: 978-1-4244-2949-3
- LIQIANG YANG ET AL: "Solution-Processed Flexible Polymer Solar Cells with Silver Nanowire Electrodes", ACS APPLIED MATERIALS & INTERFACES, vol. 3, no. 10, 7 septembre 2011 (2011-09-07), pages 4075-4084, XP055140323, ISSN: 1944-8244, DOI: 10.1021/am2009585
- DRECHSEL J ET AL: "Efficient organic solar cells based on a double p-i-n architecture using doped wide-gap transport layers", APPLIED PHYSICS LETTERS, AMERICAN INSTITUTE OF PHYSICS, US, vol. 86, no. 24, 7 juin 2005 (2005-06-07), pages 244102-244102, XP012065900, ISSN: 0003-6951, DOI: 10.1063/1.1935771

## Description

La présente invention concerne le domaine des cellules photovoltaïques organiques.

Les cellules photovoltaïques, dites organiques comprennent généralement un empilement multicouche comportant une couche photo-active, dite couche « active ». Cette couche active est dénommée « I » et elle est en général constituée d'un ou plusieurs matériaux semi-conducteurs, intrinsèques ou d'un mélange de matériaux de type P et de type N. Ces matériaux semi-conducteurs sont généralement des molécules organiques ou des polymères ou des composés organométalliques halogénés. Cette couche active est au contact de part et d'autre avec une couche de type N et une couche de type P. La couche de type P est généralement constituée d'un mélange de poly(3,4-éthylènedioxythiophène) (PEDOT) et de poly(styrène sulfonate) de sodium (PSS), ou d'un oxyde semi-conducteur de type P, par exemple WO₃, MoO₃, V₂O₅ ou encore NiO. La couche de type N est généralement constituée d'un oxyde semi-conducteur de type N, par exemple ZnO, AZO (oxyde de zinc dopé à l'aluminium) ou TiOₓ. Ce type d'ensemble multicouche, constitué de la superposition de la couche active I et des deux couches de type P et de type N décrites ci-dessus est classiquement dénommé NIP ou PIN.

Le rendement électrique d'une cellule photovoltaïque organique est particulièrement dépendant du spectre d'absorption de la lumière de la couche active.

Pour améliorer ce rendement, il est élaboré des cellules photovoltaïques organiques de type multijonction, et en particulier dites de type « tandem » ou à double jonction. De telles cellules de type tandem comportent deux ensembles multicouches PIN et/ou NIP tels que décrits ci-dessus, empilés l'un sur l'autre, et dont les couches actives respectives présentent généralement des spectres d'absorption de la lumière différents. Il est à noter que dans le cas de cellules photovoltaïques organiques de type tandem, l'ensemble multicouche NIP ou PIN est généralement désigné comme une simple jonction. Dans ces cellules de type tandem, les photons non absorbés par la première couche active peuvent l'être par la seconde. La quantité de photons récupérée par l'ensemble des couches actives de la cellule est ainsi augmentée et le rendement électrique de cette dernière, amélioré.

A titre illustratif des cellules photovoltaïques organiques de type tandem, on peut tout particulièrement citer les cellules dites « 2 fils » et les cellules dites « 3 fils ».

Dans une cellule de type 2 fils, l'empilement multicouche définit un montage électrique en série. La couche supérieure de l'ensemble multicouche inférieur, de type N ou P, forme avec la couche inférieure de l'ensemble multicouche supérieur, respectivement de type P ou N, un élément multicouche de recombinaison des porteurs de charge (électrons et trous), dont l'épaisseur est généralement comprise entre 40 nm et 200 nm. Pour recombiner plus efficacement les porteurs de charge, il peut être interposé une couche métallique et semi-transparente, en particulier en argent, qui recouvre substantiellement complètement l'interface entre les deux couches constituant ledit élément multicouche de recombinaison.

Néanmoins, l'intensité J du courant dans une cellule 2 fils demeure limitée par l'ensemble multicouche le moins efficace.

Les cellules dites « 3 fils » permettent notamment de surmonter ce handicap.

Ainsi, la cellule « 3 fils » décrite dans l'article « High-efficiency polymer tandem solar cells with three terminal structure », Srivinas Sista et al., Adv. Mater., 2010, 22, E77-E80, est constituée d'un assemblage constitué d'un ensemble multicouche NIP superposé à un ensemble multicouche PIN, de première et deuxième électrodes disposées de part et d'autre et au contact de chaque ensemble multicouche NIP ou PIN, et d'une électrode centrale, formée d'une couche d'or, disposée à l'interface entre les deux ensembles multicouche NIP et PIN. Dans un tel assemblage, les électrodes inférieure et supérieure sont en contact et sont reliées à l'électrode centrale, de manière à former un montage en parallèle des ensembles multicouche PIN et NIP. Ainsi, le courant total J dans ce type de cellule photovoltaïque ne s'avère pas être affecté par une différence de courant potentielle entre les deux ensembles multicouches respectivement PIN et NIP.

Comme décrit précédemment, un assemblage de type tandem précité intègre en outre une couche métallique. Toutefois, la mise en œuvre de cette couche métallique impose certaines contraintes.

Ainsi, la couche métallique située à l'interface entre les ensembles multicouche PIN et/ou NIP de l'assemblage se doit de ne pas être trop épaisse à des fins de garantir une transmittance élevée pour que les photons puissent, après avoir traversé la première couche active et la couche métallique, atteindre la seconde couche active. Or, il est connu, comme l'atteste l'article « *Highly efficient organic tandem solar cells: a follow up review* », Ameri Tabeyeh *et al.*, qu'une réduction de l'épaisseur de cette couche métallique peut provoquer des problèmes de conduction, nuisibles au rendement de la cellule photovoltaïque.

Enfin, par opposition aux couches actives, de type N et de type P classiquement déposées par voie humide, le dépôt de cette couche métallique requiert une technique par évaporation sous vide. Sur le plan industriel, cette technique s'avère coûteuse et non aisée de mise en œuvre.

Des alternatives aux électrodes métalliques sont déjà connues. Elles mettent à profit d'autres matériaux conducteurs tels que les mélanges de polymères, par exemple de PEDOT et de PSS, les composites métal-polymère, les grilles métalliques, les nanofils métalliques, les nanotubes de carbone, le graphène, et les oxydes métalliques. Dans l'article « Flexible ITO-Free Polymer Solar Cells », Dechan Angmo, Frecerik C. Krebs, J. Appl. Polym. Sci., vol. 129, num. 1, 1-14, 2013, DOI:10.1002/app.38854., il est notamment proposé la mise en œuvre à titre d'électrode supérieure transparente d'un réseau de nanofils d'argent. Des feuilles de nanotubes de carbone sont utilisés dans WO 2012/106002 A1 à titre d'exemple pratique, pour les électrodes de captage de charge. Toutefois, la rugosité élevée du réseau de nanofils peut aboutir à la création de courts circuits. En outre, les zones vides entre les nanofils d'argent limitent la capacité d'extraction des charges entre la couche N ou P adjacente et l'électrode. Enfin, le travail de sortie du réseau de nanofils d'argent n'est pas adapté pour l'extraction des charges. WO 2015/116200 A1 décrit une couche intermédiaire utile pour coupler deux dispositifs photovoltaïques organiques individuels afin de fournir un dispositif photovoltaïque organique en tandem, qui comprend une première couche de transport de trous, une première couche de transport d'électrons, et une couche de nanostructure métallique intercalée entre la couche de transport de trous et la première couche de transport d'électrons. La couche de nanostructure métallique fournit un point de recombinaison efficace pour les électrons et les trous. La couche de nanostructure métallique peut comprendre des nanofils d'argent qui permettent la formation de la couche de nanostructure métallique en utilisant un processus à base de solution à basse température qui n'a pas d'effet défavorable sur les couches sous-jacentes.

En conséquence, il demeure un besoin pour un empilement multicouche pour une cellule organique de type multijonction, en particulier de type tandem, 2 fils ou plus, dont la mise au point soit dénuée au moins en partie des problèmes décrits ci-dessus.

La présente invention a précisément pour objet de répondre à cette attente.

Ainsi, la présente invention concerne un empilement multicouche selon la revendication 1.

Contre toute attente, les inventeurs ont en effet constaté qu'un empilement selon l'invention s'avère particulièrement avantageux pour former une cellule photovoltaïque de type multijonction, en particulier de type tandem.

Tout d'abord, il permet d'accéder à un compromis avantageux en termes de résistivité de surface et de transmittance.

Par ailleurs, le réseau de nanofils peut présenter une épaisseur supérieure à celle d'une couche métallique, mais inférieure à celle de la couche qu'il intègre. Le réseau conducteur ainsi formé permet une recombinaison ou une extraction efficace des transporteurs de charge avec une faible diminution de la transmittance de l'empilement par rapport à un empilement ne comportant pas le réseau de nanofils.

Ainsi, une cellule photovoltaïque organique de type multijonction, et en particulier de type tandem, comportant un empilement selon l'invention présente un rendement énergétique amélioré par rapport aux cellules photovoltaïques organiques de type multijonction, et en particulier de type tandem, de l'art antérieur.

L'invention concerne aussi un procédé de fabrication selon la revendication 13.

Le procédé selon l'invention est plus simple à mettre en œuvre et moins coûteux que les procédés de fabrication d'empilements comportant une étape d'évaporation sous vide d'une couche métallique de l'art antérieur. En particulier, l'ensemble des étapes de dépôt de revêtement pour former l'empilement multicouche selon l'invention peut être effectué par voie humide. En outre, toutes les étapes de dépôt des différentes couches de l'empilement peuvent ainsi être effectuées avec un même dispositif de dépôt.

L'invention concerne également une cellule photovoltaïque de type multijonction, et en particulier de type tandem, comportant un empilement multicouche selon l'invention.

Avantageusement, l'élément multicouche de recombinaison peut être plus épais que dans une cellule photovoltaïque organique de type tandem 2 fils de l'art antérieur, tout en présentant une transmittance sensiblement identique. Il est ainsi possible de moduler le champ optique de l'élément multicouche de recombinaison pour augmenter la quantité de photons collectés par les couches actives, et sans perdre en résistivité de surface ou mobilité des porteurs de charge.

L'invention pourra être mieux comprise à la lecture de la description détaillée qui va suivre et à l'examen du dessin annexé, sur lequel :
- les figures 1 et 2 illustrent des empilements de cellules photovoltaïques organiques de type tandem 3 fils hors invention,
- les figures 3 et 4 illustrent des empilements de cellules photovoltaïques organiques de type tandem 2 fils selon l'invention,
- les figures 5 et 6 illustrent une couche intermédiaire intégrant un réseau de nanofils d'un empilement selon l'invention, en vue latérale et en vue de dessus respectivement, et
- les figures 7 et 8 illustrent des étapes du procédé de fabrication d'un empilement selon différents modes de mise en œuvre.

Dans les différentes figures, les organes identiques ou analogues ont été repérés avec une même référence. Dans le dessin annexé, les proportions réelles des divers éléments constitutifs de l'empilement n'ont pas été toujours respectées dans un souci de clarté.

### EMPILEMENT

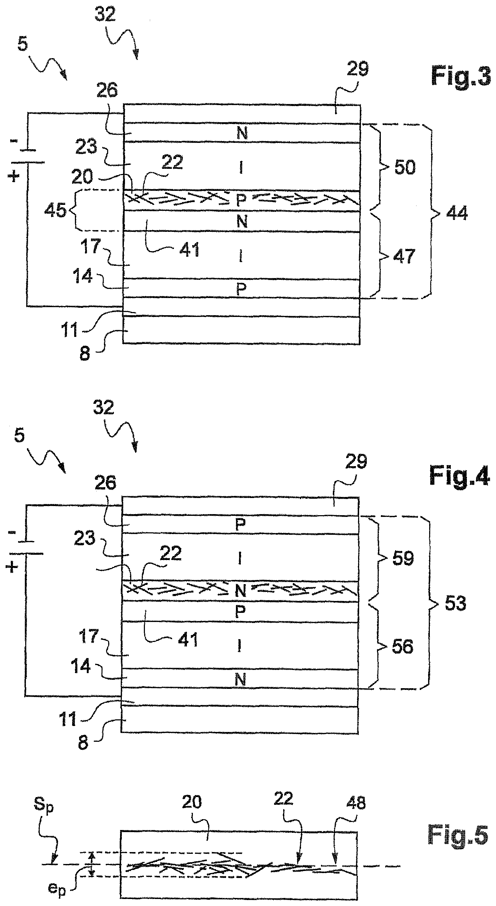

Comme cela est illustré par exemple sur la figure 3, un empilement 5 selon l'invention peut notamment comporter une succession de couches superposées et jointives les unes aux autres dans l'ordre suivant :
- une première couche externe 14,
- une première couche active 17,
- une couche intermédiaire 20 qui intègre un réseau 22 de nanofils,
- une deuxième couche active 23, et
- une deuxième couche externe 26,

Comme on le verra par la suite, dans un mode de réalisation particulier, l'empilement peut en outre comporter une couche additionnelle disposée entre la première couche active ou la deuxième active d'une part et la couche intermédiaire d'autre part.

Il est décrit un exemple hors invention, dans lequel un empilement multicouche est plus particulièrement destiné à être utilisé pour former une cellule photovoltaïque organique de type tandem 3 fils. Dans ce cas, la couche intermédiaire est directement au contact des première et deuxième couches actives. Autrement dit, l'empilement ne comporte alors pas de couche additionnelle.

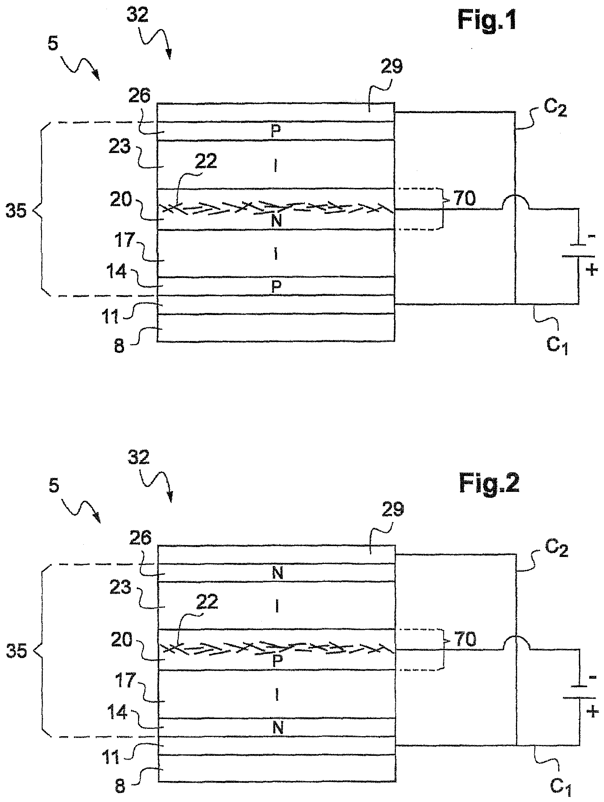

Plus particulièrement, comme illustré sur la figure 1, l'empilement selon l'exemple hors invention forme un assemblage multicouche de type PINIP 35, constitué d'une première couche externe de type P, d'une première couche active, d'une couche intermédiaire de type N, d'une deuxième couche active et d'une deuxième couche externe de type P.

En variante, comme illustré sur la figure 2, un exemple d'empilement hors invention forme un assemblage multicouche de type NIPIN 38, constitué de la première couche externe de type N, de la première couche active, de la couche intermédiaire de type P, de la deuxième couche active et de la deuxième couche externe de type N.

Comme cela est illustré sur les figures 1 et 2, le réseau 22 de nanofils de l'exemple d'empilement hors invention est de préférence disposé sensiblement à mi-distance de l'interface entre la première couche active et la couche intermédiaire d'une part, et de l'interface entre la deuxième couche active et la couche intermédiaire d'autre part. Il est destiné à former l'électrode centrale de la cellule photovoltaïque organique tandem type 3 fils. De préférence, dans cette variante, les nanofils qui constituent le réseau sont métalliques, et en particulier comportent, voire sont constitués d'un métal choisi parmi l'argent, l'or, le cuivre ou leurs alliages. L'argent est un métal préféré.

Dans un mode de réalisation de l'invention illustré sur les figures 3 et 4, l'empilement multicouche est plus particulièrement destiné à être utilisé pour former une cellule photovoltaïque organique de type tandem 2 fils. Dans ce cas, l'empilement comporte une couche additionnelle 41, intercalée entre la première couche active et la deuxième couche active et directement au contact de la première couche active ou de la deuxième couche active, la couche additionnelle étant d'un type P ou N, distinct de celui formant la couche intermédiaire 20.

De préférence, la couche additionnelle est intercalée entre la couche intermédiaire d'une part et la première couche active ou la deuxième couche active d'autre part, et est au contact de la couche intermédiaire d'une part et de la première couche active ou de la deuxième couche active d'autre part.

Plus particulièrement, un empilement selon ledit mode de réalisation peut former un assemblage multicouche de type PINPIN 44 constitué d'un premier ensemble multicouche de type PIN 47 comportant une première couche externe de type P, une première couche active, une couche intermédiaire de type N ou une couche additionnelle de type N, et d'un deuxième ensemble de type PIN 50 comportant une couche additionnelle de type P ou une couche intermédiaire de type P, une deuxième couche active et une deuxième couche externe de type N. Un tel exemple d'empilement de type PINPIN est illustré sur la figure 3.

En variante, comme illustré sur la figure 4, un empilement selon ledit mode de réalisation peut former un assemblage multicouche de type NIPNIP 53 constitué d'un premier ensemble multicouche de type NIP 56 comportant une première couche externe de type N, une première couche active, une couche intermédiaire de type P ou une couche additionnelle de type P, et d'un deuxième ensemble multicouche de type NIP 59 comportant une couche additionnelle de type N ou une couche intermédiaire de type N, une deuxième couche active et une deuxième couche externe de type P.

Selon le mode de réalisation de l'invention, comme cela est illustré sur les figures 3 et 4, le réseau 22 de nanofils est de préférence au moins partiellement au contact de la couche additionnelle, et s'étend de préférence à l'interface entre la couche intermédiaire et la couche additionnelle. Ainsi, l'ensemble formé par la couche intermédiaire intégrant le réseau de nanofils et la couche additionnelle forme un élément multicouche de recombinaison des charges pour la cellule photovoltaïque organique tandem de type 2 fils.

### RESEAU DE NANOFILS

Le réseau de nanofils de l'empilement est formé d'un assemblage irrégulier et désordonné de nanofils. Notamment, le réseau de nanofils ne présente pas de distance caractéristique selon laquelle un motif élémentaire et caractéristique du réseau est reproduit. Ainsi, un réseau est différent d'une grille.

De préférence, le réseau 22 de nanofils s'étend parallèlement à la couche intermédiaire 20. De préférence, moins de 5 %, moins de 1 %, voire substantiellement aucun des nanofils du réseau de nanofils n'est en contact avec la première couche active et/ou la deuxième couche active. D'une façon préférée, le réseau de nanofils est dénué de contact avec lesdites première et deuxième couches actives.

Comme cela est schématiquement illustré sur la figure 5, le réseau 22 de nanofils s'étend de préférence le long d'une surface sensiblement plane Sₚ, appelé plan de réseau ci-dessous, de préférence parallèle à l'interface entre la couche intermédiaire 20 et la couche immédiatement supérieure et/ou immédiatement inférieure et au contact de la couche intermédiaire.

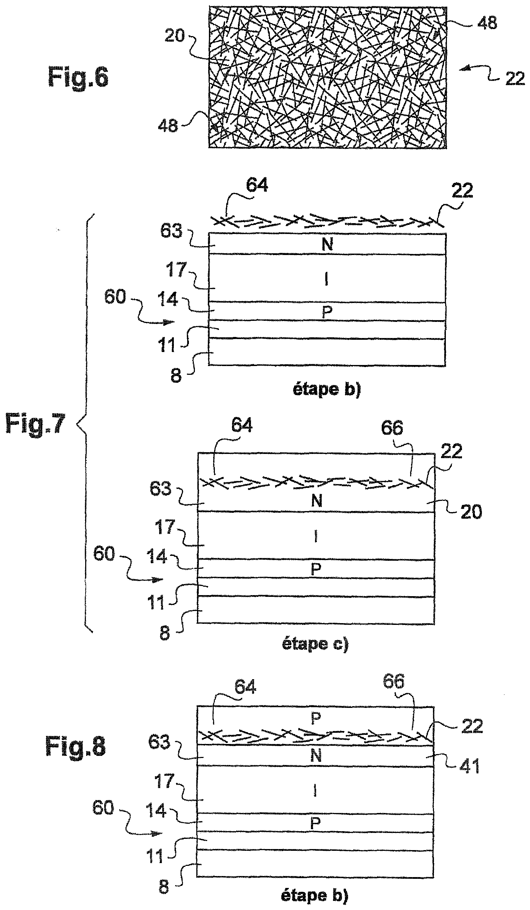

De préférence, les nanofils formant le réseau de nanofils peuvent être distribués de manière isotrope au sein de ce réseau comme cela peut être observé sur la figure 6.

De préférence, la répartition des nanofils au sein du réseau de nanofils est homogène.

De préférence, la densité en nanofils du réseau, exprimée en masse équivalente d'argent par unité de surface, est comprise entre 0,01 g/m² et 0,05 g/m². Par quantité de nanofils exprimée en masse équivalente d'argent constituant les nanofils, on considère la masse totale du volume des nanofils considérés qui seraient constitués d'argent, quel que soit le matériau qui constitue les nanofils.

De préférence, l'épaisseur eₚ du réseau de nanofils est inférieure à 300 nm, de préférence inférieure ou égale à 200 nm, et est plus particulièrement comprise entre 40 nm et 200 nm.

De préférence, la couche intermédiaire, observée selon une direction verticale, est telle que la fraction surfacique occupée par le réseau de nanofils représente moins de 80 %, moins de 50 %, moins de 30 %, voire moins de 10 %.

Dans le cas d'une cellule photovoltaïque organique tandem de type 3 fils hors invention, les nanofils du réseau de nanofils 22 ont des points de contact avec des nanofils distincts du réseau de nanofils. On parle alors de percolation entre les nanofils, ce qui permet au réseau 22 de jouer le rôle d'électrode centrale pour la cellule photovoltaïque. Le réseau de nanofils peut aussi être percolant lorsque l'empilement qui le comporte est destiné à une cellule photovoltaïque tandem de type 2 fils.

Notamment, dans le cas d'une cellule photovoltaïque organique tandem de type 2 fils, le réseau de nanofils 22 n'a pas nécessairement besoin d'être percolant puisque l'ensemble formé avec la couche intermédiaire et la couche additionnelle est destiné à former un élément multicouche de recombinaison de porteurs de charges.

Ainsi, dans une variante de réalisation, en particulier, le réseau de nanofils est non percolant, c'est-à-dire que les nanofils sont dénués de contact les uns avec les autres.

L'aptitude du réseau de nanofils à extraire les charges de la couche adjacente peut être évaluée en mesurant son travail de sortie. Dans le cas où le réseau de nanofils est constitué de nanofils d'argent et/ou de nanofils de cuivre, le travail de sortie du réseau de nanofils est de préférence compris entre 4,7 eV et 5,2 eV.

De préférence, les nanofils qui constituent le réseau sont métalliques, et en particulier comportent, voire sont constitués d'un métal choisi parmi l'argent, l'or, le cuivre ou leurs alliages. L'argent est un métal préféré.

De préférence, les nanofils présentent un diamètre moyen supérieur à 10 nm, de préférence supérieur à 20 nm, et inférieur à 1000 nm, de préférence inférieur à 150 nm. De préférence, ils présentent une longueur moyenne supérieure ou égale à 1 µm et inférieure ou égale à 500 µm, de préférence inférieure ou égale à 30 µm. En particulier, le rapport d'élancement moyen des nanofils est de préférence supérieur à 100.

Le diamètre d'un nanofil peut être compris entre 10 nm et 1000 nm. La longueur d'un nanofil peut être comprise entre 1 µm et 100 µm, de préférence comprise entre 5 µm et 20 µm.

De préférence, plus de 70 %, plus de 90 %, voire substantiellement tous les nanofils présentent un rapport d'aspect supérieur à 100.

### COUCHE INTERMEDIAIRE

Le réseau de nanofils est intégré dans une couche intermédiaire qui présente avantageusement au moins l'une des caractéristiques décrites ci-dessus.

Elle est formée au moins en partie, voire complètement d'un matériau de type P ou de type N. Un matériau de type N permet le transport des électrons. Un matériau de type P permet le transport des trous. Un matériau de type P ou de type N peut être un oxyde conducteur ou semi-conducteur, ou un polymère conducteur ou semi-conducteur.

Le matériau de type P peut être par exemple choisi parmi le poly(3,4-éthylènedioxythiophène) (PEDOT) : poly(styrène sulfonate) de sodium (PSS), le Nafion, WO₃, MoO₃, V₂O₅ et NiO, et leurs mélanges.

Un matériau de type P préféré est le mélange de PEDOT et de PSS.

Un matériau de type N peut être par exemple choisi parmi le polyéthylènimine ethoxylé (PEIE), le poly[(9,9-bis(3'-(N,N-diméthylamino)propyl)-2,7-fluorène)-alt-2,7-(9,9-dioctylfluorène) (PFN), ZnO, les oxydes de titane TiOₓ avec x compris entre 1 et 2, l'oxyde de zinc dopé à l'aluminium (AZO), l'oxyde de zinc dopé à l'indium (IZO), l'oxyde de zinc dopé au gallium (GZO), et leurs mélanges.

Des matériaux de type N préférés sont ZnO et TiOₓ.

Dans le cas où la couche intermédiaire comporte un matériau de type N, le travail de sortie du réseau de nanofils est de préférence compris entre 4,0 eV [électron-Volt] et 4,8 eV. Dans le cas où la couche intermédiaire comporte un matériau de type P, le travail de sortie du réseau de nanofils est de préférence compris entre 4,8 eV et 5,3 eV.

Selon l'exemple hors invention, de préférence, l'épaisseur de la couche intermédiaire est supérieure ou égale à 100 nm et inférieure ou égale à 500 nm. Elle peut être mesurée avec un microscope à force atomique AFM de dénomination commerciale VEECO/INNOVA ou avec un profilomètre de dénomination commerciale KLA Tencor.

De préférence, selon l'exemple hors invention, la transmittance de la couche intermédiaire est supérieure à 50 % et/ou la résistivité de surface de la couche intermédiaire est inférieure à 200 Ω/sq, de préférence inférieure à 100 Ω/sq.

Selon le mode de réalisation de l'invention, de préférence, l'épaisseur de la couche intermédiaire est supérieure ou égale à 100 nm et inférieure ou égale à 500 nm.

### AUTRES COUCHES DE L'EMPILEMENT

Comme décrit précédemment, selon le mode de réalisation de l'invention, l'empilement comporte une couche additionnelle en un matériau de type P ou de type N distinct de celui de la couche intermédiaire, en particulier en un polymère de type P ou N et/ou en un oxyde de type P ou N respectivement, tel que décrit ci-dessus.

De préférence, la couche intermédiaire est alors en ZnO et la couche additionnelle est alors en un mélange de PEDOT et de PSS.

En variante, la couche intermédiaire est en un mélange de PEDOT et de PSS et la couche additionnelle est en ZnO.

La couche additionnelle présente de préférence une épaisseur comprise entre 50 nm et 300 nm.

L'ensemble constitué par la couche intermédiaire et la couche additionnelle présente de préférence une épaisseur supérieure ou égale à 100 nm et inférieure ou égale à 500 nm. De préférence, la transmittance de l'ensemble constitué par la couche intermédiaire et la couche additionnelle est supérieure à 50 % et/ou la résistivité de surface de l'ensemble constitué par la couche intermédiaire et la couche additionnelle est inférieure 200 Ω/sq, de préférence inférieure à 100 Ω/sq.

Selon le mode de réalisation, l'empilement comporte aussi des première et deuxième couches actives disposées de part et d'autre de la couche intermédiaire, et le cas échéant de la couche additionnelle.

La première couche active peut être en un mélange de matériaux différent de celui de la deuxième couche active, de sorte à présenter un spectre d'absorption de la lumière différent du spectre de la deuxième couche active.

Elle peut aussi être formée d'un même mélange de matériaux.

Le choix des matériaux et les épaisseurs des première et deuxième couches actives peut être fait de manière classique dans le domaine des cellules photovoltaïques organiques de type multijonction. Les matériaux choisis sont en particulier des molécules organiques et/ou des polymères. Selon une variante, le ou les matériaux des couches actives pourraient aussi être choisis parmi les composés organométalliques halogénés tels que CH₃NH₃PbI₂, le plomb pouvant être remplacé par l'étain ou le germanium et l'iode pouvant être remplacé par le chlore ou le brome. Une telle cellule photovoltaïque peut dans ce cas, être désignée comme une cellule photovoltaïque en pérovksite, du fait du matériau constituant la ou les couches actives, l'architecture d'une telle cellule n'en restant pas moins identique à celle d'une cellule photovoltaïque organique multijonction. Ainsi, dans le cadre de la présente invention, on peut assimiler une telle cellule photovoltaïque en pérovskite à une cellule photovoltaïque organique multijonction.

A titre illustratif, un exemple d'empilement hors invention peut comporter :
- une première couche active constituée d'un mélange de P3HT et de PCBM,
- une couche intermédiaire qui intègre un réseau de nanofils d'argent et constituée de ZnO, et
- une deuxième couche active constituée d'un mélange de P3HT et de PCBM.

A titre illustratif, un exemple d'empilement hors invention peut comporter :
- une première couche active constituée d'un mélange de P3HT et de PCBM,
- une couche intermédiaire qui intègre un réseau de nanofils d'argent et constituée d'un mélange de PEDOT et de PSS, et
- une deuxième couche active constituée d'un mélange de P3HT et de PCBM.

Pour sa part, un empilement selon le mode de réalisation de l'invention peut comporter :
- une première couche active constituée d'un mélange de P3HT et de PCBM,
- une couche additionnelle constituée d'un mélange de PEDOT et de PSS,
- une couche intermédiaire qui intègre un réseau de nanofils d'argent et constituée de ZnO,
- une deuxième couche active constituée d'un mélange de P3HT et de PCBM.

En variante préférée, un empilement selon le mode de réalisation de l'invention, comportant une couche intermédiaire de type P et une couche additionnelle de type N peut comporter :
- une première couche active constituée d'un mélange de P3HT et de PCBM,
- une couche additionnelle constituée de ZnO,
- une couche intermédiaire qui intègre un réseau de nanofils d'argent et constituée d'un mélange de PEDOT et de PSS,
- une deuxième couche active constituée d'un mélange de P3HT et de PCBM.

Notamment, comme illustré sur les figures 3 et 4, l'empilement selon l'invention peut aussi comporter des première et deuxième couches externes.

De préférence, les première et deuxième couches externes sont en un matériau de type N ou P, de préférence choisi parmi les polymère et/ou oxyde de type N ou P tels que décrits ci-dessus pour constituer la couche intermédiaire. Les matériaux constitutifs des première et deuxième couches externes peuvent être différents. En variante, ils sont identiques.

L'épaisseur de la première couche externe et/ou la deuxième couche externe peut être supérieure à 20 nm, voire supérieure à 50 nm et/ou inférieure à 250 nm, voire inférieure à 200 nm, voire encore inférieure à 100 nm.

### PROCEDE DE FABRICATION

Le procédé de fabrication d'un empilement selon l'invention est tel que l'ensemble des étapes de dépôt pour former l'empilement selon l'invention peut être effectué par voie humide, c'est-à-dire par une technique mettant en œuvre le dépôt d'une solution liquide.

En particulier, le dépôt d'une solution au cours du procédé de fabrication, peut être réalisé au moyen d'une technique choisie parmi le dépôt à la tournette, le dépôt au racloir, le dépôt par spray ultrasonique, l'enduction par filière à fente, l'impression jet d'encre, l'héliogravure, la flexographie ou la sérigraphie. Notamment, tous les revêtements déposés au cours des étapes du procédé peuvent être déposés à l'aide d'une unique technique choisie parmi celles décrites ci-dessus. En particulier, la technique de dépôt peut aussi être choisie par l'homme du métier en fonction des propriétés fluides et des constituants de la solution à déposer. Une couche peut être obtenue par au moins une, voire plusieurs étapes de dépôt.

De préférence, une solution déposée lors de la mise en œuvre du procédé comporte un solvant. Le solvant peut être de l'eau et/ou du diméthyl sulfoxyde et/ou un alcool, par exemple choisi parmi l'isopropanol, l'éthanol, le méthanol, le glycérol, l'éthylène glycérol, ou leurs mélanges.

Les caractéristiques spécifiques aux différentes étapes du procédé sont décrites ci-dessous.

L'étape a) met en œuvre une structure multicouche 60 formée au moins en partie d'une première couche active en contact avec un premier revêtement de type P ou de type N.

Comme cela est illustré sur la figure 7, la structure multicouche 60 peut être avantageusement figurée par un support 8 sur lequel est disposée une succession de couches superposées les unes aux autres.

Dans un mode de réalisation préféré, elle peut comporter :
- un support 8,
- une première électrode 11,
- une première couche externe 14,
- une première couche active 17,
- un premier revêtement 63.

Notamment, la première couche externe et le premier revêtement peuvent être constitués des matériaux de type N ou de type P décrits précédemment. Les couches constitutives de la structure multicouche 60 considérée à l'étape a) peuvent être obtenues par voie humide.

Ainsi, le premier revêtement peut être au préalable formé en déposant en surface externe de la première couche active une solution dans des conditions propices à sa formation. Cette solution peut comporter un matériau de type N ou P, en particulier un polymère et/ou un oxyde de type P, mis en solution dans un solvant, en particulier tel que décrit précédemment et peut aussi comporter un tensioactif et/ou un agent de viscosité tel que décrit ci-dessus.

De préférence, ce premier revêtement présente une épaisseur comprise entre 20 nm et 100 nm.

Le procédé met en œuvre à l'étape b) un dépôt sur le premier revêtement d'une première solution comportant des nanofils et optionnellement un matériau de type P ou de type N, dans des conditions propices à la formation, en surface dudit premier revêtement, d'un deuxième revêtement intégrant un réseau de nanofils.

L'étape b) peut aboutir à la formation de premier et deuxième revêtements structurellement différents, suivant qu'elle est mise en œuvre selon un premier mode ou un deuxième mode tels que décrits ci-dessous.

Dans un premier mode de mise en œuvre de l'étape b), illustré sur la figure 7, la première solution peut alors consister en une dispersion de nanofils dans un solvant tel que décrit précédemment. La concentration de nanofils, exprimés en masse équivalente d'argent constituant les nanofils par litre de première solution, est alors de préférence comprise entre 0,1 g/l et 10 g/l.

La première solution peut être déposée sur le premier revêtement de sorte à former un réseau de nanofils au moyen d'une méthode de dépôt telle que décrite précédemment, et en particulier par enduction par filière à fente, ou par héliogravure, ou par impression jet d'encre, ou de préférence par spray ultrasonique. L'homme du métier sait adapter les paramètres de dépôt pour déposer une quantité suffisante de nanofils de façon à former un réseau de nanofils conducteur après élimination du solvant de la première solution.

De préférence, ce premier mode de mise en œuvre résulte, à la fin de l'étape b), dans la formation d'un deuxième revêtement 64 constitué par le réseau 22 de nanofils.

De préférence, les paramètres de dépôt de la première solution sont adaptés de sorte qu'à la fin de l'étape b), la transmittance du réseau de nanofils est supérieure à 70 % et la résistivité de surface du réseau de nanofils est inférieure à 50 Ω/sq, et/ou la densité surfacique du réseau de nanofils, exprimée en masse équivalente d'argent constituant les nanofils par unité de surface, est comprise entre 0,005g/m² et 0,1g/m², plus particulièrement comprise entre 0,01 g/m² et 0,05 g/m².

Dans un deuxième mode de mise en œuvre de l'étape b), illustré sur la figure 8, la première solution déposée à l'étape b) comporte un matériau de type P ou de type N, tel que décrit précédemment. En particulier, la première solution à l'étape b) peut alors être obtenue par mélange de première et deuxième préparations liquides.

Le type P ou N du matériau de la première solution déposée à l'étape b) est différent du type P ou N du matériau du premier revêtement.

La première préparation liquide peut consister en une dispersion de nanofils dans un solvant tel que décrit précédemment dans une concentration supérieure ou égale à 0,1g/l, de préférence supérieure ou égale à 0,5 g/l, et inférieure ou égale à 10 g/l, de préférence inférieure ou égale à 5 g/l.

La deuxième préparation liquide peut, pour sa part, comporter une teneur massique en matériau de type P ou de type N comprise entre 1 % et 40 %. Pour former la deuxième préparation liquide, un polymère de type P ou de type N est de préférence mis en solution dans l'eau. En alternative, un oxyde métallique de type P ou de type N peut être mis en solution dans l'eau et/ou dans un alcool tel que décrit ci-dessus. La deuxième préparation liquide peut en outre comporter un agent de viscosité et/ou un tensioactif pour modifier la viscosité et/ou la tension de surface de la première solution.

La première solution, constituée des première et deuxième préparations liquides est de préférence déposée à la tournette, ou au racloir, ou par spray ultrasonique, ou par enduction par filière à fente, ou par impression jet d'encre.

Dans ce deuxième mode de mise en œuvre, les paramètres de dépôt de la première solution sont adaptés de préférence de sorte qu'à la fin de l'étape b), la transmittance de la succession des premier revêtement 63, réseau de nanofils et deuxième revêtement 64 est supérieure à 50 % et la résistivité de surface de la succession du réseau de nanofils et du deuxième revêtement est inférieure à 100 Ω/sq, et/ou la densité surfacique du réseau de nanofils d'argent, exprimée en masse équivalente d'argent constituant les nanofils par unité de surface, est comprise entre 0,01 g/m² et 0,05 g/m².

Dans une variante, le procédé selon l'invention peut comporter en outre une étape b') effectuée après l'étape b) et avant l'étape c), consistant à déposer une solution comportant des nanofils sur le premier revêtement formé à l'étape b) dans des conditions propices à la formation d'un revêtement se superposant au premier revêtement et sur lequel est déposé par la suite le deuxième revêtement. Cette solution comporte alors de préférence un matériau de même type N ou P que la première solution, de sorte que le premier revêtement et le revêtement formé à l'étape b') définissent une couche intermédiaire homogène intégrant un réseau de nanofils présentant une densité en nanofils variable selon l'épaisseur de la couche. Il est décrit un exemple hors invention selon lequel une telle étape b') peut notamment être mise en œuvre pour la fabrication d'un empilement hors invention utile pour une cellule photovoltaïque de type 3 fils.

Le procédé selon l'invention met aussi optionnellement en œuvre une étape c) qui consiste à déposer sur le deuxième revêtement formé à l'étape b) une deuxième solution comportant un matériau de type P ou de type N, identique à celui de la première solution, dans des conditions propices à la formation d'un troisième revêtement (66).

L'étape c) est en particulier mise en œuvre lorsqu'à l'étape b), la première solution consiste en une dispersion de nanofils dans un solvant selon le premier mode de mise en œuvre du procédé tel que décrit ci-dessus. De préférence, la deuxième solution est alors déposée directement sur le réseau de nanofils formé à l'étape b).

La deuxième solution comprend de préférence un matériau de type P ou N dans un solvant tel que décrit précédemment. La deuxième solution mise en œuvre à l'étape c) peut en particulier être identique à celle mise en œuvre à l'étape a).

De préférence, la quantité de deuxième solution déposée à l'étape c) est adaptée pour qu'après élimination du solvant, l'épaisseur du troisième revêtement 66 soit supérieure à l'épaisseur du réseau de nanofils formé à la fin de l'étape b). De préférence, l'épaisseur du troisième revêtement est comprise entre 50 nm et 400 nm.

De préférence, à la fin de l'étape c), le troisième revêtement intègre au moins partiellement, de préférence complètement le deuxième revêtement, en particulier constitué du réseau de nanofils, formé à l'étape b).

De cette façon, le réseau de nanofils forme une structure électriquement conductrice au sein d'une matrice comportant un matériau de type P ou de type N et constituée au moins en partie par le troisième revêtement.

De préférence, les paramètres de dépôt de la deuxième solution sont adaptés de préférence de sorte qu'à la fin de l'étape c), la transmittance de l'ensemble constitué par le premier 63, deuxième 64 et troisième 66 revêtements est de préférence supérieure à 50 % et la résistivité de surface du troisième revêtement 66 est de préférence inférieure à 100 Ω/sq.

Les revêtements formés aux étapes a), b) et le cas échéant c) forment une couche intermédiaire et une couche additionnelle de l'empilement.

En particulier, le premier revêtement constitue la couche additionnelle 41 d'une part, et le deuxième revêtement, et optionnellement le troisième revêtement, constituent la couche intermédiaire 20 d'autre part.

La figure 7 illustre une étape c) d'un procédé hors invention où les premier 63, deuxième 64, et optionnellement troisième 66 revêtements constituent une couche intermédiaire 20 d'un empilement hors invention.

Le choix du type N ou P du matériau constituant chacun des revêtements des étapes a), b) et c) du procédé de l'invention permet de former à la fin de l'étape b) ou le cas échéant de l'étape c) un élément multicouche de recombinaison 45 de porteurs de charge d'une cellule photovoltaïque comportant un empilement selon l'invention, comme cela sera décrit ci-dessous.

Selon un exemple hors invention, lorsqu'à l'étape a), le premier revêtement comporte un matériau de type N, respectivement de type P, et qu'à l'étape b) et/ou à l'étape c), le deuxième et/ou le troisième revêtement comporte(nt) un matériau de type N, respectivement de type P, l'assemblage des premier, deuxième et le cas échéant troisième revêtements constitue la couche intermédiaire, intégrant un réseau de nanofils de type N, respectivement de type P, d'un empilement hors invention.

Selon l'invention, lorsqu'à l'étape a), le premier revêtement comporte un matériau de type P, respectivement de type N, et qu'à l'étape b) et/ou à l'étape c), le deuxième et/ou le troisième revêtement comporte(nt) un matériau de type N, respectivement de type P, le premier revêtement peut constituer la couche additionnelle d'un empilement selon l'invention, de type P, respectivement de type N. Le deuxième revêtement, et le cas échéant le troisième revêtement, définissent la couche intermédiaire de type N, respectivement de type P, de l'empilement selon l'invention.

Le procédé comporte une étape **d**), consécutive à l'étape c), consistant à déposer une deuxième couche active, par exemple différente de la première couche active, sur le deuxième revêtement formé à l'étape b) ou le cas échéant sur le troisième revêtement formé à l'étape c). L'homme du métier sait alors déterminer les conditions de dépôt et les constituants des solutions à déposer de façon à former un empilement utile pour une cellule photovoltaïque de type multijonction, et en particulier de type tandem selon l'invention.

### CELLULE PHOTOVOLTAÏQUE

Une cellule photovoltaïque organique de type multijonction et en particulier de type tandem selon l'invention comporte un empilement selon l'invention.

Notamment, comme illustré sur les figures 3 à 4, elle peut comporter une succession de couches superposées et jointives les unes aux autres, dans l'ordre suivant :
- un support 8, se présentant de préférence sous la forme d'une plaque, par exemple en verre ou en matière plastique, de préférence en PEN et/ou en PET,
- une première électrode 11, ou électrode inférieure,
- un assemblage formé en tout ou partie d'un empilement multicouche selon l'invention tel que décrit précédemment, et
- une deuxième électrode 29, ou électrode supérieure.

La cellule photovoltaïque comporte de préférence des moyens de connexion électrique (non représentés sur la figure 1), notamment des reprises de contact, qui permettent de relier les électrodes pour alimenter en courant un circuit électrique.

La première électrode, au contact du support, est par exemple formée d'une couche en un matériau choisi parmi l'oxyde d'étain dopé à l'indium (ITO), l'oxyde de zinc dopé à l'aluminium (AZO), l'oxyde de zinc dopé au gallium (GZO), l'oxyde de zinc dopé à l'indium (IZO) et leurs mélanges, ou formée d'un ensemble multicouche AZO/Ag/AZO. Elle peut aussi être constituée par un réseau de nanofils métalliques tel que décrit précédemment, de préférence constitué de nanofils d'argent.

La deuxième électrode est de préférence formée par une couche en argent, ou par un réseau de nanofils, de préférence en argent.

Dans un exemple hors invention, il est décrit une cellule photovoltaïque comportant l'exemple d'empilement hors invention, c'est-à-dire comportant une couche intermédiaire intercalée et au contact des première et deuxième couches actives.

Elle peut être alors telle que la couche intermédiaire de l'empilement constitue une électrode centrale 70, comme illustré sur les figures 1 et 2. La première électrode centrale peut être reliée à la deuxième électrode, par une méthode classique connue de l'homme du métier. Les première et deuxième électrodes peuvent être reliées à l'électrode centrale via un circuit électrique. La cellule photovoltaïque organique et de type tandem peut ainsi être de type « 3 fils ».

La cellule photovoltaïque selon l'invention peut comporter un empilement selon le mode de réalisation de l'invention, c'est-à-dire comportant une couche additionnelle 41 intercalée entre la couche intermédiaire 20 d'une part et la première couche active 17 ou la deuxième couche active 23 d'autre part. Elle peut alors être une cellule de type « 2 fils ».

De préférence, le réseau de nanofils 22, la couche intermédiaire 20 et la couche additionnelle 41 de l'empilement forment un élément multicouche de recombinaison 45 favorisant la recombinaison des porteurs de charges au sein de l'empilement.

### EXEMPLES

Les exemples non limitatifs suivants sont présentés dans le but d'illustrer l'invention.

### Exemple 1 hors invention

La fabrication de la cellule photovoltaïque de l'exemple 1 est réalisée en suivant les étapes successives décrites ci-dessous.
i) Un support en polynaphtalate d'éthylène (PEN) est préalablement préparé pour le dépôt de couches. Des reprises de contact chrome/or sont déposées sur le support, puis le support est dégraissé et traité par plasma d'oxygène.
ii) Une première électrode est formée sur le support en déposant sur une face du support, par spray ultrasonique, une solution de nanofils d'argent dilués dans du méthanol à une teneur de 0,5 grammes par litre de méthanol. Ce dépôt est réalisé en effectuant plusieurs balayages successifs sur la face du support jusqu'à former un réseau de nanofils d'argent en surface du support présentant une résistivité de surface électrique supérieure à 10 Ω/sq et inférieure à 50 Ω/sq. Le réseau de nanofils est ensuite comprimé à l'aide d'une presse à une température de 80 °C, pendant 30 minutes. Après ce traitement, la résistivité de surface et la transmittance sont mesurées et sont respectivement inférieure à 25 Ω/sq et environ égale à 90%.
iii) Un premier revêtement de type N de ZnO, est ensuite déposé sur la première électrode. Pour cela, une solution est préparée, comportant 6 % de ZnO, en pourcentage massique sur la masse de la solution, le reste étant constitué d'éthanol. Elle est déposée à la tournette pendant 30 secondes, la vitesse de rotation de la tournette étant fixée à 1000 tours/minute. Les reprises de contact sont alors lavées avec un coton-tige imprégné d'isopropanol (IPA). La structure multicouche obtenue par ces premiers dépôts de couches est ensuite recuite pendant 5 minutes à une température de 140 °C.
iv) Un mélange constitué en parts volumiques de 93 % d'orthodichlorobenzène (oCDB) et de 7 % de méthyl-naphtalène est ensuite préparé à titre de solvant. Dans ce solvant sont ajoutés 38 grammes par litre de solvant de Poly(3-hexylthiphene) (P3HT) et du [6,6]-phényl-C61-butanoate de méthyle (PCBM), le rapport la masse de P3HT sur la masse de PCBM étant de 1/0,88, de manière à former une solution pour le dépôt d'une première couche active. Cette solution est ensuite déposée sur la structure multicouche, à la tournette tournant à une vitesse de rotation de 1500 tours par minutes pendant 40 secondes, de façon à former une première couche active sur le premier revêtement de ZnO préalablement formé. Les reprises de contact sont alors lavées à l'oCDB, puis la structure multicouche comportant à présent la première couche active est recuite pendant 10 minutes à une température de 120 °C.
v) Une premier revêtement de mélange de PEDOT et de PSS (nommé aussi PEDOT:PSS), est ensuite formé sur la structure multicouche formée à l'étape précédente, par dépôt à la tournette d'une solution de PEDOT:PSS de dénomination commerciale Heraeus HTL Solar, d'abord à une vitesse de rotation de 1500 tours par minute pendant 25 secondes, puis à une vitesse de 3000 tours par minute pendant 25 secondes. Les reprises de contact sont alors lavées à l'isopropanol ou à l'eau déionisée. Le susbtrat est alors recuit à une température de 120 °C pendant 10 minutes dans une boîte à gants.
vi) Un réseau de nanofils d'argent est formé sur le revêtement de PEDOT:PSS d'une manière identique à celle détaillée à l'étape i).
vii) Un deuxième revêtement de PEDOT:PSS est formé sur le réseau de nanofils formé à l'étape vi) suivant la méthode décrite à l'étape v).
viii) Une deuxième couche active est formée sur la deuxième couche de PEDOT:PSS en suivant une méthode identique en tous points à celle décrite à l'étape iv).

Ainsi, le premier revêtement de PEDOT:PSS, le réseau de nanofils formé à l'étape vi) et le deuxième revêtement de PEDOT:PSS définissent ensemble une électrode centrale sous la forme d'une couche intermédiaire au contact des première et deuxième couches actives.
ix) Un second revêtement de ZnO de type N est ensuite formé sur la deuxième couche active dans des conditions identiques à celles décrites à l'étape iii), la vitesse de rotation de la tournette étant fixée à 2000 tours par minute.
x) Enfin, une deuxième électrode en argent d'une épaisseur de 100 nm est formée sur la structure multicouche obtenue à l'étape ix) par évaporation sous vide.

De cette façon, un assemblage de type NIPIN est obtenu tel qu'illustré par exemple sur la figure 7.

Une cellule photovoltaïque organique de type tandem « 3 fils » comportant l'assemblage obtenu à l'aide des étapes i) à x) décrites ci-dessus présente un rendement moyen de 3 %, supérieur de 0,5 points au rendement d'une cellule photovoltaïque organique tandem classique présentant une électrode centrale constituée d'un film d'argent déposé par évaporation sous vide.

### Exemple 2 hors invention

L'exemple 2 diffère notamment de l'exemple 1 en ce que le support est en verre et l'électrode inférieure est en oxyde indium étain (ITO).

L'assemblage est obtenu en suivant les étapes i) à x) de l'exemple 1. Il présente un rendement moyen de 3 %, supérieur de 0,5 points au rendement d'une cellule tandem classique présentant une électrode centrale constituée d'un film d'argent déposé par évaporation sous vide.

### Exemple 3

La préparation de l'exemple 3 ne diffère de l'exemple 1 qu'en ce que les étapes vii) et ix) sont interverties de façon à former respectivement des étapes ix') et vii'), la vitesse de rotation à l'étape vii') étant néanmoins fixée à 1000 tours par minute.

Ainsi, le premier revêtement de PEDOT:PSS et le réseau de nanofils formé à l'étape vi) forment une couche intermédiaire, le deuxième revêtement de ZnO formé à l'étape vii') constitue une couche additionnelle. Ces couches intermédiaire et additionnelle forment ensemble un élément multicouche de recombinaison de porteurs de charge.

De cette façon, un assemblage de type NIP/NIP est obtenu. Une cellule photovoltaïque organique de type tandem « 2 fils » intégrant l'empilement de l'exemple 3, telle que représentée schématiquement sur la figure 5, présente un rendement moyen de 3 %, supérieur de 0,5 points au rendement d'une cellule photovoltaïque organique de type tandem classique présentant une couche de recombinaison de porteurs de charge constituée d'un film d'argent déposé par évaporation sous vide.

L'invention n'est bien évidemment pas limitée aux modes de réalisation décrits et représentés.

## Revendications

1. Empilement multicouche (5) utile pour former une cellule photovoltaïque organique et de type multijonction (32), ledit empilement comportant des première (17) et deuxième (23) couches actives, et une couche intermédiaire (20) de type P ou de type N, intercalée entre lesdites première et deuxième couches actives et au contact d'au moins une des première et deuxième couches, l'empilement multicouche comportant une couche additionnelle (41), intercalée entre la première couche active et la deuxième couche active et directement au contact de la première couche active ou de la deuxième couche active, la couche additionnelle étant d'un type P ou N, distinct de celui formant la couche intermédiaire, **caractérisé en ce que** la ladite couche intermédiaire intègre un réseau (22) de nanofils électriquement conducteurs,.

2. Empilement selon la revendication précédente, le réseau de nanofils s'étendant parallèlement à la couche intermédiaire.

3. Empilement selon l'une quelconque des revendications précédentes, le réseau de nanofils étant dénué de contact avec lesdites première et deuxième couches actives.

4. Empilement selon l'une quelconque des revendications précédentes, l'épaisseur de la couche intermédiaire étant supérieure ou égale à 100 nm et inférieure ou égale à 500 nm.

5. Empilement selon l'une quelconque des revendications précédentes, le réseau de nanofils étant au moins partiellement au contact de la couche additionnelle et/ou s'étendant à l'interface entre la couche intermédiaire et la couche additionnelle.

6. Empilement selon l'une quelconque des revendications précédentes, le réseau de nanofils étant non percolant.

7. Empilement selon l'une quelconque des revendications précédentes, dans lequel l'ensemble constitué par la couche intermédiaire et la couche additionnelle présente une épaisseur supérieure ou égale à 100 nm et inférieure ou égale à 500 nm.

8. Empilement selon l'une quelconque des revendications précédentes, la transmittance de l'ensemble constitué par la couche intermédiaire et la couche additionnelle étant supérieure à 50 %.

9. Empilement selon l'une quelconque des revendications précédentes, la résistivité de surface de l'ensemble constitué par la couche intermédiaire et la couche additionnelle étant inférieure à 200 Ω/sq, de préférence inférieure à 100 Ω/sq.

10. Empilement selon l'une quelconque des revendications précédentes, les nanofils étant métalliques, de préférence constitués d'un métal choisi parmi l'argent, le cuivre, l'or et leurs alliages.

11. Empilement selon l'une quelconque des revendications précédentes, les nanofils présentant un diamètre moyen supérieur ou égal à 10 nm, de préférence supérieur ou égal à 20 nm, et inférieur ou égal à 1000 nm, de préférence inférieur ou égal à 150 nm, et une longueur moyenne supérieure ou égale à 1 µm et inférieure ou égale à 500 µm, de préférence inférieure ou égale à 30 µm.

12. Empilement selon l'une quelconque des revendications précédentes, le matériau de la couche intermédiaire et/ou de la couche additionnelle étant choisi dans le groupe formé par
- les polymères de type P et les oxydes de type P, en particulier le mélange de poly(3,4-éthylènedioxythiophène) (PEDOT) et de poly(styrène sulfonate) de sodium (PSS), le Nafion, WO₃, MoO₃, V₂O₅ et NiO et leurs mélanges,
ou
- les polymères de type N et les oxydes de type N, en particulier le polyéthylènimine ethoxylé (PEIE), le poly[(9,9-bis(3'-(N,N-diméthylamino)propyl)-2,7-fluorène)-alt-2,7-(9,9-dioctylfluorène) (PFN), ZnO, les oxydes de titane TiOₓ avec x compris entre 1 et 2, l'oxyde de zinc dopé à l'aluminium (AZO), l'oxyde de zinc dopé à l'indium (IZO), l'oxyde de zinc dopé au gallium (GZO), et leurs mélanges.

13. Procédé de fabrication d'un empilement, comprenant au moins les étapes consistant à :
a) disposer d'une première couche active en contact avec un premier revêtement (63) de type P ou de type N,
b) déposer sur ledit premier revêtement une première solution comportant des nanofils et optionnellement un matériau de type P ou de type N, dans des conditions propices à la formation, en surface dudit premier revêtement, d'un deuxième revêtement (64) intégrant un réseau (22) de nanofils,
c) optionnellement, déposer sur le deuxième revêtement formé à l'étape b) une deuxième solution comportant un matériau de type P ou de type N, identique à celui de la première solution, dans des conditions propices à la formation d'un troisième revêtement (66),
le premier revêtement constituant la couche additionnelle d'une part, et le deuxième revêtement, et optionnellement le troisième revêtement, constituant la couche intermédiaire d'autre part, d'un empilement selon l'une quelconque des revendications précédentes.

14. Procédé selon la revendication précédente, comportant une étape d), consécutive à l'étape c), consistant à former une deuxième couche active sur le deuxième revêtement formé à l'étape b) ou sur le troisième revêtement formé à l'étape c).

15. Cellule photovoltaïque organique de type multijonction, et en particulier de type tandem (32), comportant un empilement selon l'une quelconque des revendications 1 à 12, dans laquelle de préférence le réseau de nanofils, la couche intermédiaire et la couche additionnelle de l'empilement forme un élément multicouche de recombinaison de porteurs de charges (45).

## Patentansprüche

1. Mehrschichtiger Stapel (5), der dazu dient, eine organische Mehrfachphotovoltaikzelle (32) zu bilden, wobei der Stapel erste (17) und zweite (23) aktive Schichten und eine Zwischenschicht (20) vom p-Typ oder vom n-Typ beinhaltet, die zwischen den ersten und zweiten aktiven Schichten eingefügt ist und mit mindestens einer der ersten und zweiten Schichten in Kontakt ist, wobei der mehrschichtige Stapel eine zusätzliche Schicht (41) beinhaltet, die zwischen der ersten aktiven Schicht und der zweiten aktiven Schicht eingefügt ist und direkt in Kontakt mit der ersten aktiven Schicht oder der zweiten aktiven Schicht ist, wobei die zusätzliche Schicht von einem p- oder n-Typ ist, der verschieden von dem ist, der die Zwischenschicht bildet, **dadurch gekennzeichnet, dass** die Zwischenschicht ein Gitter (22) aus elektrisch leitfähigen Nanofäden aufnimmt.

2. Stapel nach dem vorhergehenden Anspruch, wobei sich das Gitter aus Nanofäden parallel zur Zwischenschicht erstreckt.

3. Stapel nach einem der vorhergehenden Ansprüche, wobei das Gitter aus Nanofäden keinen Kontakt zu den ersten und zweiten aktiven Schichten hat.

4. Stapel nach einem der vorhergehenden Ansprüche, wobei die Dicke der Zwischenschicht größer oder gleich 100 nm ist und kleiner oder gleich 500 nm ist.

5. Stapel nach einem der vorhergehenden Ansprüche, wobei das Gitter aus Nanofäden zumindest teilweise in Kontakt mit der zusätzlichen Schicht ist und/oder sich an der Grenzfläche zwischen der Zwischenschicht und der zusätzlichen Schicht erstreckt.

6. Stapel nach einem der vorhergehenden Ansprüche, wobei das Gitter aus Nanofäden nicht perkolierend ist.

7. Stapel nach einem der vorhergehenden Ansprüche, bei dem die aus der Zwischenschicht und der zusätzlichen Schicht bestehende Anordnung eine Dicke größer oder gleich 100 nm und kleiner oder gleich 500 nm aufweist.

8. Stapel nach einem der vorhergehenden Ansprüche, wobei die Transmission der aus der Zwischenschicht und der zusätzlichen Schicht bestehenden Anordnung mehr als 50 % beträgt.

9. Stapel nach einem der vorhergehenden Ansprüche, wobei der spezifische Oberflächenwiderstand der aus der Zwischenschicht und der zusätzlichen Schicht bestehenden Anordnung kleiner als 200 Ω/sq, bevorzugt kleiner als 100 Ω/sq ist.

10. Stapel nach einem der vorhergehenden Ansprüche, wobei die Nanofäden metallisch sind, bevorzugt aus einem Metall bestehen, das unter Silber, Kupfer, Gold und ihren Legierungen gewählt ist.

11. Stapel nach einem der vorhergehenden Ansprüche, wobei die Nanofäden einen mittleren Durchmesser größer oder gleich 10 nm, bevorzugt größer oder gleich 20 nm, und kleiner oder gleich 1000 nm, bevorzugt kleiner oder gleich 150 nm, und eine mittlere Länge größer oder gleich 1 µm und kleiner oder gleich 500 µm, bevorzugt kleiner oder gleich 30 µm aufweisen.

12. Stapel nach einem der vorhergehenden Ansprüche, wobei das Material der Zwischenschicht und/oder der zusätzlichen Schicht aus der Gruppe gewählt ist, die gebildet wird durch
- Polymere vom p-Typ und Oxide vom p-Typ, insbesondere dem Gemisch aus Poly(3,4-ethylendioxithiopen) (PEDOT) und Poly-(natriumstyrolsulfonat) (PSS), Nafion, WO3, MoO3, V2O5 und NiO und ihren Gemischen,
oder
- Polymere vom n-Typ und Oxide vom n-Typ, insbesondere das Polyethylenimin-Ethoxylat (PEIE), das Poly[(9,9-bis(3'-(N,N-dimethylamino)propyl)-2,7- fluoren)-alt-2,7-(9,9-dioctylfluoren) (PFN), ZnO, die Titanoxide TiOx mit x zwischen 1 und 2, das aluminiumdotierte Zinkoxid (AZO), das indiumdotierte Zinkoxid (IZO), das galliumdotierte Zinkoxid (GZO) und ihre Mischungen.

13. Verfahren zur Herstellung eines Stapels, umfassend mindestens die folgenden Schritte:
a) Bereitstellen einer ersten aktiven Schicht, die in Kontakt mit einem ersten Überzug (63) vom p-Typ oder n-Typ ist,
b) Aufbringen einer ersten Lösung, die Nanofäden und optional ein Material vom p-Typ oder vom n-Typ umfasst, auf den ersten Überzug unter Bedingungen, die günstig für die Bildung eines zweiten Überzugs (64), der ein Gitter (22) aus Nanofäden beinhaltet, auf der Oberfläche des ersten Überzugs sind,
c) optional Aufbringen einer zweiten Lösung, die ein Material vom p-Typ oder n-Typ beinhaltet, das identisch mit dem der ersten Lösung ist, auf den im Schritt b) gebildeten zweiten Überzug unter Bedingungen, die günstig für die Bildung eines dritten Überzugs (66) sind,
wobei der erste Überzug die zusätzliche Schicht einerseits und der zweite Überzug und optional der dritte Überzug die Zwischenschicht andererseits eines Stapels nach einem der vorhergehenden Ansprüche darstellen.

14. Verfahren nach dem vorhergehenden Anspruch, beinhaltend einen auf den Schritt c) folgenden Schritt d), der darin besteht, eine zweite aktive Schicht auf dem im Schritt b) gebildeten zweiten Überzug oder auf dem im Schritt c) gebildeten dritten Überzug zu bilden.

15. Organische Mehrfachphotovoltaikzelle und insbesondere Tandemphotovoltaikzelle (32), die einen Stapel nach einem der Ansprüche 1 bis 12 beinhaltet, bei der bevorzugt das Gitter aus Nanofäden, die Zwischenschicht und die zusätzliche Schicht des Stapels ein mehrschichtiges Ladungsträgerrekombinationselement (45) bilden.

## Claims

1. Multilayer stack (5) of use in forming an organic photovoltaic cell and of multi junction type (32), the said stack comprising first (17) and second (23) active layers, and an intermediate layer (20) of P type or of N type inserted between the said first and second active layers and in contact with at least one of the first and second layers, the multilayer stack comprising an additional layer (41), inserted between a first active layer and a second active layer and directly in contact with the first active layer or with the second active layer, the additional layer being of a P or N type, distinct from that forming the intermediate layer, **characterized in that** the said intermediate layer incorporates a network (22) of electrically conductive nanowires.

2. Stack according to the preceding claim, the network of nanowires extending parallel to the intermediate layer.

3. Stack according to either one of the preceding claims, the network of nanowires being devoid of contact with the said first and second active layers.

4. Stack according to any one of the preceding claims, the thickness of the intermediate layer being greater than or equal to 100 nm and less than or equal to 500 nm.

5. Stack according to any one of the preceding claims, the network of nanowires being at least partially in contact with the additional layer and/or extending to the interface between the intermediate layer and the additional layer.

6. Stack according to any one of the preceding claims, the network of nanowires being nonpercolating.

7. Stack according to any one of the preceding claims, in which the assembly formed by the intermediate layer and the additional layer exhibits a thickness of greater than or equal to 100 nm and less than or equal to 500 nm.

8. Stack according to any one of the preceding claims, the transmittance of the assembly formed by the intermediate layer and the additional layer being greater than 50%.

9. Stack according to any one of the preceding claims, the surface resistivity of the assembly formed by the intermediate layer and the additional layer being less than 200 Ω/sq, preferably less than 100 Ω/sq.

10. Stack according to any one of the preceding claims, the nanowires being metallic, preferably formed of a metal chosen from silver, copper, gold and their alloys.

11. Stack according to any one of the preceding claims, the nanowires exhibiting a mean diameter of greater than or equal to 10 nm, preferably of greater than or equal to 20 nm, and less than or equal to 1000 nm, preferably less than or equal to 150 nm, and a mean length of greater than or equal to 1 µm and less than or equal to 500 µm, preferably less than or equal to 30 µm.

12. Stack according to any one of the preceding claims, the material of the intermediate layer and/or of the additional layer being chosen from the group formed by:
- polymers of P type and oxides of P type, in particular the mixture of poly(3,4-ethylenedioxythiophene) (PEDOT) and of sodium poly(styrenesulfonate) (PSS), Nafion, WO₃, MoO₃, V₂O₅ and NiO and their mixtures,
or
- polymers of N type and oxides of N type, in particular ethoxylated polyethylenimine (EPEI), poly[9,9-bis(3'-(N,N-dimethylamino)propyl)-2,7-fluorene]-alt-2,7-(9,9-dioctylfluorene) (PFN), ZnO, titanium oxides TiOₓ with x between 1 and 2, aluminium-doped zinc oxide (AZO), indium-doped zinc oxide (IZO), gallium-doped zinc oxide (GZO) and their mixtures.

13. Process for the manufacture of a stack, comprising at least the stages consisting in:
a) placing a first active layer in contact with a first coating (63) of P type or of N type,
b) depositing, on the said first coating, a first solution comprising nanowires and optionally a material of P type or of N type, under conditions favourable for the formation, at the surface of the first coating, of a second coating (64) incorporating a network (22) of nanowires,
c) optionally, depositing on the second coating formed in stage b), a second solution comprising material of P type or of N type, identical to that of the first solution, under conditions favourable for the formation of a third coating (66),
the first coating constituting the additional layer, on the one hand, and the second coating, and optionally the third coating, constituting the intermediate layer, on the other hand, of a stack according to any one of the preceding claims.

14. Process according to the preceding claim, comprising a stage d), consecutive to stage c), consisting of forming a second active layer on a second coating formed in stage b) or on the third coating formed in stage c).

15. Organic photovoltaic cell of multijunction type, and in particular of tandem type (32), comprising a stack according to any one of Claims 1 to 12, in which, preferably, the network of nanowires, the intermediate layer and the additional layer of the stack form a multilayer element for recombination of charge carriers (45) .
